# EUROPEAN PATENT APPLICATION

(11) **EP 4 783 129 A1**
(43) Date of publication of application: **29.07.2026**
(21) Application number: 24867127.3
(22) Date of filing: 02.08.2024
(51) Int. Cl.: G06V 20/64, G06T 17/20

(54) **CHANNEL IDENTIFICATION METHOD AND APPARATUS FOR THREE-DIMENSIONAL MODEL, AND ELECTRONIC DEVICE AND STORAGE MEDIUM**

(30) Priority: 22.09.2023 CN 202311233605
(71) Applicant: Beijing Yakebot Technology Co., Ltd, Beijing 100744 (CN)
(72) Inventor: REN, Jianyong, Beijing 100007 (CN); LIU, Jingfang, Beijing 100007 (CN)
(74) Representative: Richly & Ritschel Patentanwälte PartG mbB
(86) International application number: PCT/CN2024/109610
(87) International publication number: WO 2025/060710

(57) **Abstract**

The present disclosure relates to the technical field of computers. Provided are a tunnel identification method and apparatus for a three-dimensional model, an electronic device and a storage medium. The method includes: acquiring an array of holes corresponding to a target triangular face in a first model; in a case where there is a triangular face in the first model that shares a boundary edge with a first hole, updating the array of holes on the basis of the triangular face in the first model that shares the boundary edge with the first hole; in a case where the updated array of holes includes at least two holes, determining a first tunnel on the basis of a first target hole; using the first target hole in the updated array of holes as a new first hole, and repeatedly executing the above steps until there is no hole in the finally updated array of holes; and on the basis of all first tunnels, determining a tunnel identification result of the first model. By means of the method, the identification of all first tunnels on a first model is realized, and the accuracy and efficiency of tunnel identification are improved.

## Description

The present disclosure claims the priority from Chinese Patent Application No. 202311233605.0, filed with the China National Intellectual Property Administration on September 22, 2023 and entitled "Tunnel Identification Method and Apparatus for Three-Dimensional Model, and Electronic Device and Storage Medium", which is hereby incorporated by reference in its entirety.

### TECHNICAL FIELD

The present disclosure relates to the field of computer technology, and in particular to a tunnel identification method and apparatus for a three-dimensional model, and an electronic device and a storage medium.

### BACKGROUND

With the development of laser technology, high-precision computer models are obtained by scanning objects. These models usually contain topological noise such as holes, tunnels, small components and spikes, making the subsequent processing of the models more complicated. The topological noise needs to be removed. In the process of removing the topological noise, some tunnels in the topological structure of a model are inherent features that should not be removed. Therefore, it is necessary to identify the tunnels.

In the related art, a certain number of seed patches (about 1%) are randomly selected on the original model, and the tunnels on the model are identified based on the triangular faces within a specified radius according to the selected seed patches. However, the operations of randomly selecting a certain number of seed patches and specifying the radius range for search cause some tunnels to be missed, resulting in the low accuracy of tunnel identification.

### SUMMARY

The present disclosure provides a tunnel identification method and apparatus for a three-dimensional model, and an electronic device and a storage medium, to solve the problem of low accuracy of tunnel identification in the prior art.

The present disclosure provides a tunnel identification method for a three-dimensional model, including:
determining a first hole in a first model;
in the case where a triangular face shares a boundary edge with the first hole in the first model, updating an array of holes based on the triangular face sharing the boundary edge with the first hole and triangular faces that have been traversed in the first model; and
in the case where an updated array of holes includes at least two holes, determining a first tunnel based on a first target hole; where the first target hole is a largest hole in the updated array of holes; and the first tunnel is obtained based on two holes that are connected to each other via two triangular faces.

According to the tunnel identification method for the three-dimensional model provided by the present disclosure, in the case where the first hole for first time is obtained, the determining a first hole in a first model includes:
obtaining an array of holes corresponding to a target triangular face in the first model; where the array of holes includes a first hole corresponding to the target triangular face; and a boundary edge of the first hole is an edge of the target triangular face.

According to the tunnel identification method for the three-dimensional model provided by the present disclosure, after obtaining the first hole for first time, the determining a first hole in a first model includes:
selecting the largest hole from the updated array of holes as a new first hole.

According to the tunnel identification method for the three-dimensional model provided by the present disclosure, the updating an array of holes based on the triangular face sharing the boundary edge with the first hole in the first model, includes:
determining the number of holes based on the triangular face sharing the boundary edge with the first hole in the first model; and
updating the array of holes based on the number of holes.

According to the tunnel identification method for the three-dimensional model provided by the present disclosure, the updating the array of holes based on the number of holes, includes:
in the case where the number of holes increases, determining at least two second holes; and updating the array of holes based on the at least two second holes;
in the case where the number of holes decreases, determining closed holes; and updating the array of holes based on the closed holes; and
in the case where the number of holes remains unchanged, determining an updated first hole; and updating the array of holes based on the updated first hole.

According to the tunnel identification method for the three-dimensional model provided by the present disclosure, the determining a first tunnel based on a first target hole, includes:
determining a second target hole that shares a same boundary edge with the first target hole after updating the first target hole based on a newly traversed triangular face; and
determining the first tunnel based on the first target hole and the second target hole.

According to the tunnel identification method for the three-dimensional model provided by the present disclosure, the method further includes:
determining a tunnel closed curve of the first tunnel; where the tunnel closed curve is a closed curve corresponding to a shortest path encircling the first tunnel;
determining a length of the tunnel closed curve; and
in the case where the length of the tunnel closed curve is less than a preset threshold, repairing the first tunnel.

According to the tunnel identification method for the three-dimensional model provided by the present disclosure, the determining a tunnel closed curve of the first tunnel, includes:
copying the first model to form a second model; and
on the second model: deleting all processed triangular faces in the first model, retaining one or more triangular faces at an intersection of the first target hole and the second target hole, deleting two connected triangular faces on the first tunnel, and executing a shortest path algorithm to obtain the tunnel closed curve of the first tunnel.

According to the tunnel identification method for the three-dimensional model provided by the present disclosure, the repairing the first tunnel, includes:
deleting, based on the tunnel closed curve, triangular faces within a preset range corresponding to the tunnel closed curve, to obtain two disconnected third target holes; and
using a hole filling algorithm to fill each of the third target holes.

According to the tunnel identification method for the three-dimensional model provided by the present disclosure, the executing a shortest path algorithm to obtain the tunnel closed curve of the first tunnel, includes:
executing the shortest path algorithm based on a common edge between a triangular face traversed last in the first model and the first target hole that existed before a boundary edge was updated, to obtain a shortest tunnel closed curve encircling the first tunnel.

According to the tunnel identification method for the three-dimensional model provided by the present disclosure, triangular faces adjacent to the first hole are traversed one by one in the first model to search for the triangular face sharing the boundary edge with the first hole.

According to the tunnel identification method for the three-dimensional model provided by the present disclosure, the method further includes:
in the case where there is no untraversed triangular face that shares a boundary edge with the first hole in the first model, deleting the first hole from the array of holes; and
reselecting a largest hole from the array of holes as a new first hole, and returning to execute: in the case where a triangular face shares the boundary edge with the first hole in the first model, updating the array of holes based on the triangular face sharing the boundary edge with the first hole in the first model, until there is no hole in the array of holes.

The present disclosure provides a tunnel identification method for a three-dimensional model, including:
step A: obtaining an array of holes corresponding to a target triangular face in a first model; where the array of holes includes a first hole corresponding to the target triangular face; and a boundary edge of the first hole is an edge of the target triangular face;
step B: in the case where a triangular face shares the boundary edge with the first hole in the first model, updating the array of holes based on the triangular face sharing the boundary edge with the first hole and triangular faces that have been traversed in the first model;
step C: in the case where an updated array of holes includes at least two holes, determining a first tunnel based on a first target hole; where the first target hole is a largest hole in the updated array of holes; and the first tunnel is obtained based on two holes that are connected to each other via two triangular faces;
step D: taking the first target hole in the updated array of holes as a new first hole, and repeating steps B to D until there is no hole in a finally updated array of holes; and
step E: determining a tunnel identification result of the first model based on all first tunnels.

According to the tunnel identification method for the three-dimensional model provided by the present disclosure, the updating the array of holes based on the triangular face sharing the boundary edge with the first hole in the first model, includes:
determining the number of holes based on the triangular face sharing the boundary edge with the first hole in the first model; and
updating the array of holes based on the number of holes.

According to the tunnel identification method for the three-dimensional model provided by the present disclosure, the updating the array of holes based on the number of holes, includes:
in the case where the number of holes increases, determining at least two second holes; and updating the array of holes based on the at least two second holes;
in the case where the number of holes decreases, determining closed holes; and updating the array of holes based on the closed holes; and
in the case where the number of holes remains unchanged, determining an updated first hole; and updating the array of holes based on the updated first hole.

According to the tunnel identification method for the three-dimensional model provided by the present disclosure, the determining a first tunnel based on a first target hole, includes:
determining a second target hole that shares a same boundary edge with the first target hole after updating the first target hole based on a newly traversed triangular face; and
determining the first tunnel based on the first target hole and the second target hole.

According to the tunnel identification method for the three-dimensional model provided by the present disclosure, the method further includes:
for each of the first tunnels, determining a tunnel closed curve of the first tunnel; where the tunnel closed curve is a closed curve corresponding to a shortest path encircling the first tunnel;
determining a length of the tunnel closed curve; and
in the case where the length of the tunnel closed curve is less than a preset threshold, repairing the first tunnel.

According to the tunnel identification method for the three-dimensional model provided by the present disclosure, for each of the first tunnels, determining a tunnel closed curve of the first tunnel, includes:
copying the first model to form a second model; and
for each of the first tunnels, on the second model: deleting all processed triangular faces in the first model, retaining one or more triangular faces at an intersection of the first target hole and the second target hole, deleting two connected triangular faces on the first tunnel, and executing a shortest path algorithm to obtain the tunnel closed curve of the first tunnel.

According to the tunnel identification method for the three-dimensional model provided by the present disclosure, the repairing the first tunnel, includes:
deleting, based on the tunnel closed curve, triangular faces within a preset range corresponding to the tunnel closed curve, to obtain two disconnected third target holes; and
using a hole filling algorithm to fill each of the third target holes.

According to the tunnel identification method for the three-dimensional model provided by the present disclosure, the executing a shortest path algorithm to obtain the tunnel closed curve of the first tunnel, includes:
executing the shortest path algorithm based on a common edge between a triangular face traversed last in the first model and the first target hole that existed before a boundary edge was updated, to obtain a shortest tunnel closed curve encircling the first tunnel.

According to the tunnel identification method for the three-dimensional model provided by the present disclosure, triangular faces adjacent to the first hole are traversed one by one in the first model to search for the triangular face sharing the boundary edge with the first hole.

According to the tunnel identification method for the three-dimensional model provided by the present disclosure, the method further includes:
in the case where there is no untraversed triangular face that shares a boundary edge with the first hole in the first model, deleting the first hole from the array of holes; and
reselecting a largest hole from the array of holes as a new first hole, and returning to execute steps B to D.

The present disclosure further provides a tunnel identification apparatus for a three-dimensional model, including:
an obtaining module configured to obtain and determine a first hole in a first model;
a first updating module configured to, in the case where a triangular face shares a boundary edge with the first hole in the first model, update an array of holes based on the triangular face sharing the boundary edge with the first hole and triangular faces that have been traversed in the first model; and
a first determining module configured to, in the case where an updated array of holes includes at least two holes, determine a first tunnel based on a first target hole; where the first target hole is a largest hole in the updated array of holes; and the first tunnel is obtained based on two holes that are connected to each other via two triangular faces.

The present disclosure further provides a tunnel identification apparatus for a three-dimensional model, including:
an obtaining module configured to obtain an array of holes corresponding to a target triangular face in a first model; where the array of holes includes a first hole corresponding to the target triangular face; and a boundary edge of the first hole is an edge of the target triangular face;
a first updating module configured to, in the case where a triangular face shares the boundary edge with the first hole in the first model, update the array of holes based on the triangular face sharing the boundary edge with the first hole and triangular faces that have been traversed in the first model;
a first determining module configured to, in the case where an updated array of holes includes at least two holes, determine a first tunnel based on a first target hole; where the first target hole is a largest hole in the updated array of holes;
an execution module configured to take the first target hole in the updated array of holes as a new first hole, and repeat the above steps until there is no hole in a finally updated array of holes; and
a second determining module configured to determine a tunnel identification result of the first model based on all first tunnels.

The present disclosure further provides an electronic device, including a memory, a processor, and a computer program stored in the memory and executable on the processor, where the processor implements any tunnel identification method for the three-dimensional model as described above when executing the program.

The present disclosure further provides a non-transitory computer-readable storage medium storing a computer program thereon, where the computer program, when executed by a processor, implements any tunnel identification method for the three-dimensional model as described above.

The present disclosure further provides a computer program product, including a computer program, which implements any tunnel identification method for the three-dimensional model as described above when executed by a processor.

In the tunnel identification method and apparatus for the three-dimensional model, the electronic device and the storage medium provided by the present disclosure, the array of holes corresponding to the target triangular face in the first model is obtained, where the array of holes includes the first hole corresponding to the target triangular face, and the boundary edge of the first hole is the edge of the target triangular face; in the case where a triangular face shares the boundary edge with the first hole in the first model, the array of holes is updated based on the triangular face sharing the boundary edge with the first hole in the first model; in the case where the updated array of holes includes at least two holes, the first tunnel is determined based on the first target hole, where the first target hole is the largest hole in the updated array of holes, and the first tunnel is obtained based on two holes that are connected to each other via two triangular faces; the first target hole in the updated array of holes is used as a new first hole, and the above steps are repeated until all holes in the array of holes have no common triangular face; and the tunnel identification result of the first model is determined based on all the first tunnels. By traversing all triangular faces that share the boundary edge with the first hole on the model and traversing each triangular face only once, the identification of all the first tunnels on the first model can be ensured, thereby improving the accuracy and efficiency of tunnel identification.

It should be understood that the content described in this part is not intended to identify critical or essential features of embodiments of the present disclosure, nor is it used to limit the scope of the present disclosure. Other features of the present disclosure will be easily understood through the following description.

### BRIEF DESCRIPTION OF THE DRAWINGS

In order to illustrate the technical solutions in the present disclosure or in the prior art more clearly, the accompanying figures which need to be used in describing the embodiments or the prior art will be introduced below briefly. Obviously, the accompanying figures described below are some embodiments of the present disclosure, and other accompanying figures can also be obtained by those ordinary skilled in the art according to these accompanying figures without creative labor.
FIG. 1 is a schematic flow chart of a tunnel identification method for a three-dimensional model according to an embodiment of the present disclosure.
FIG. 2 is a schematic flow chart of a tunnel identification method for a three-dimensional model according to an embodiment of the present disclosure.
FIG. 3 is a schematic diagram of increasing the number of holes according to an embodiment of the present disclosure.
FIG. 4 is a schematic diagram of decreasing the number of holes according to an embodiment of the present disclosure.
FIG. 5 is a schematic diagram of not changing the number of holes according to an embodiment of the present disclosure.
FIG. 6 is a schematic diagram of a first tunnel according to an embodiment of the present disclosure.
FIG. 7 is a schematic structural diagram of a tunnel identification apparatus for a three-dimensional model according to an embodiment of the present disclosure.
FIG. 8 is a schematic structural diagram of a tunnel identification apparatus for a three-dimensional model according to an embodiment of the present disclosure.
FIG. 9 is a schematic structural diagram of an electronic device according to an embodiment of the present disclosure.

### DETAILED DESCRIPTION

In order to make the purposes, technical solutions and advantages of the present disclosure clearer, the technical solutions in the present disclosure will be described clearly and completely below in combination with the accompanying drawings in the present disclosure. Obviously, the described embodiments are a part of the embodiments of the present disclosure but not all the embodiments. Based upon the embodiments in the present disclosure, all of other embodiments obtained by those ordinary skilled in the art without creative work pertain to the protection scope of the present disclosure.

In order to facilitate the clearer understanding of the embodiments of the present disclosure, the key terms provided in the embodiments of the present disclosure are introduced as follows.

Model: a three-dimensional model, is a polygonal representation of an object, usually displayed by a computer or other video devices. The object displayed may be a real-world entity or a fictional object. Anything that exists in physical nature can be represented by a three-dimensional model. The model in the present disclosure refers to a three-dimensional model composed of multiple triangular faces. Models composed of other polygonal patches can be converted into the form of triangular faces before applying the method of the present disclosure.

Triangular face: individual triangular face making up a model.

Edge and boundary edge: each triangular face making up a model has three edges, called edges of the model, and two adjacent triangular faces have a common edge; if one edge is only used by one triangular face, this edge is called boundary edge.

Mesh: defined by a collection of polygons, to represent the topology and spatial structure of the surface contour of a three-dimensional model. The mesh in the present disclosure is composed of a collection of triangular faces.

Hole: a closed polygon formed by a set of boundary edges connected end to end. The boundary edge is a boundary edge making up the hole.

Tunnel: a tunnel is formed by connecting the boundary edges of two disconnected holes using a triangular face.

Hole filling algorithm: an algorithm for filling a hole on a model to make the hole closed.

Topology: refers to the structure composed of vertices, edges and faces of a model.

Model No. 1: an original model, called first model hereafter.

Model No. 2: a model enlarged by continuously copying adjacent triangular faces from the original model, starting from a triangular face copied from the original model.

Model No. 3: a replica of the original model, called second model hereafter.

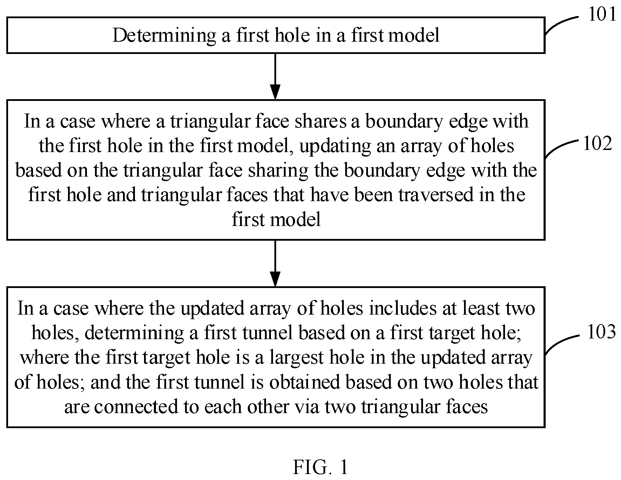

In order to identify a tunnel in a three-dimensional model, as shown in FIG. 1, an embodiment of the present disclosure provides an identification method, including:
101: determining a first hole in a first model.

In the embodiment of the present disclosure, any hole in the first model may be selected as the first hole.

In order to find the initial point as quickly as possible, in the embodiment of the present disclosure, in the case where the first hole is obtained for the first time, the step of determining the first hole in the first model may be implemented as: obtaining an array of holes corresponding to a target triangular face in the first model; where the array of holes includes a first hole corresponding to the target triangular face; and a boundary edge of the first hole is an edge of the target triangular face. That is, the first model is traversed starting from any triangular face, and the hole constructed by the any triangular face is the first hole. This manner can determine the first hole as quickly as possible, so as to identify a tunnel in the first model by traversing the surrounding triangular faces.

Accordingly, after the first hole is obtained for the first time, the first hole needs to be continuously updated in order to find all tunnels accurately and quickly. Specifically, as the first model is traversed, the array of holes is continuously updated. Accordingly, the step of determining the first hole in the first model may be implemented as: selecting the largest hole from the updated array of holes as a new first hole. Therefore, the operations shown in FIG. 1 are executed cyclically for each first hole, and thus the first tunnel in the first model can be found by traversing the first model.

102: in the case where a triangular face shares a boundary edge with the first hole in the first model, updating an array of holes based on the triangular face sharing the boundary edge with the first hole and triangular faces that have been traversed in the first model.

103: in the case where an updated array of holes includes at least two holes, determining a first tunnel based on a first target hole; where the first target hole is a largest hole in the updated array of holes; and the first tunnel is obtained based on two holes that are connected to each other via two triangular faces.

In the embodiment of the present disclosure, the first hole in the first model is firstly located, and the triangular faces in the first model are traversed by searching for the adjacent triangular face sharing the boundary edge based on the first hole, thereby finding the potential first tunnel. This method is easy to implement and can identify all first tunnels in the first model by traversing, without missing tunnels due to setting the radius range of the seed patch, thereby improving the accuracy of tunnel identification.

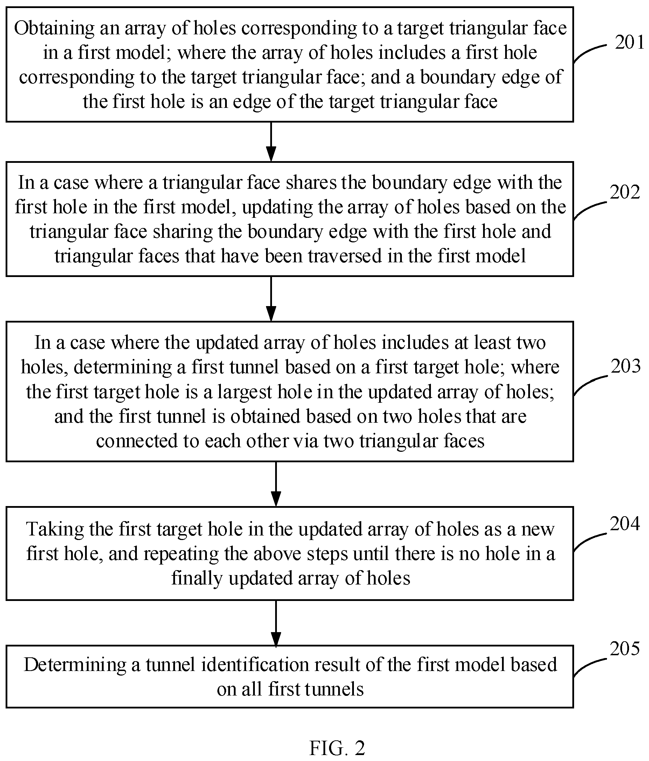

For ease of understanding, a specific manner to identify a tunnel will be described below in combination with FIG. 2.

FIG. 2 is a schematic flow chart of a tunnel identification method for a three-dimensional model according to an embodiment of the present disclosure. As shown in FIG. 2, this method includes steps 201 to 205:

Step 201: obtaining an array of holes corresponding to a target triangular face in a first model; where the array of holes includes a first hole corresponding to the target triangular face; and a boundary edge of the first hole is an edge of the target triangular face.

It should be noted that the tunnel identification method for the three-dimensional model provided in the present disclosure is applicable to the scenario of tunnel identification of the three-dimensional model, for example, tunnel identification of the three-dimensional model of the oral cavity. The execution subject of the method may be a tunnel identification apparatus for a three-dimensional model, such as an electronic device, or a control module for executing the tunnel identification method for the three-dimensional model in the tunnel identification apparatus for the three-dimensional model.

Specifically, the first model is the original three-dimensional model, namely, model No. 1. There is at least one tunnel or no tunnel on the first model. The first model may include a plurality of sub-models. These sub-models are independent of each other, such as two independent spheres. Each sub-model is composed of a plurality of triangular faces. There may be at least one tunnel or no tunnel on each sub-model.

For each sub-model, a target triangular face F is randomly selected from the sub-model in the first model. The three edges of the target triangular face F may form the first hole, recorded as hole No. 0. The boundary edge of the first hole is the edge of the target triangular face. Based on the target triangular face, an array of holes corresponding to the target triangular face is created. The hole information of the first hole is added to the array of holes. The hole information may include edge identifiers of three edges of the target triangular face and a hole identifier of the first hole.

Step 202: in the case where a triangular face shares the boundary edge with the first hole in the first model, updating the array of holes based on the triangular face sharing the boundary edge with the first hole and triangular faces that have been traversed in the first model.

Specifically, the triangular faces that share the boundary edge with the first hole in the first model are traversed to judge whether there is a triangular face that shares the boundary edge with the first hole in the first model. In the case where a triangular face shares the boundary edge with the first hole in the first model, the triangular face sharing the boundary edge with the first hole (i.e., the triangular face adjacent to the target triangular face F) is selected on the first model. The array of holes may be updated according to the triangular face sharing the boundary edge with the first hole in the first model.

During implementation, the triangular faces adjacent to the first hole are traversed one by one in the first model to search for the triangular face sharing the boundary edge with the first hole, thereby dynamically updating the array of holes.

It can be understood that the triangular faces traversed from the first model are constructed into the model No. 2 described above. As the triangular faces of the first model are traversed, the triangular faces in the model No. 2 are gradually added and updated, and the array of holes is updated based on the updated model No. 2.

It can be understood that, during actual implementation, it is not necessary to construct the model No. 2. The model No. 2 here is only used as an example to help understand that the array of holes changes dynamically as the number of triangular faces that have been traversed increases.

Step 203: in the case where an updated array of holes includes at least two holes, determining a first tunnel based on a first target hole; where the first target hole is a largest hole in the updated array of holes; and the first tunnel is obtained based on two holes that are connected to each other via two triangular faces.

Specifically, in the case where the updated array of holes includes at least two holes, the first tunnel may be determined according to the largest hole in the updated array of holes. Here, the triangular faces that share the boundary edge with the first hole are traversed one by one, so that the first tunnel is obtained based on two holes that are connected to each other via two triangular faces. It should be noted that the holes connected to the first target hole are deleted from the array of holes after the first tunnel is determined.

Step 204: taking the first target hole in the updated array of holes as a new first hole, and repeating steps 202 to 204 until there is no hole in a finally updated array of holes.

Specifically, the first target hole in the updated array of holes is used as a new first hole, and the above steps 202 to 204 are repeated until there is no hole in the updated array of holes, that is, all the triangular faces on the sub-model have been processed. That is to say, there is no triangular face that shares the boundary edge with the first hole in the sub-model, or all the triangular faces that share the boundary edge with the first hole have been traversed.

Step 205: determining a tunnel identification result of the first model based on all first tunnels.

Specifically, all first tunnels are determined respectively according to each sub-model, the tunnel identification result of the first model can be determined, and the tunnel identification result includes the first tunnels of all the sub-models.

In the tunnel identification method for the three-dimensional model provided by the present disclosure, the array of holes corresponding to the target triangular face in the first model is firstly obtained. The array of holes includes the first hole corresponding to the target triangular face, and the boundary edge of the first hole is an edge of the target triangular face. Afterwards, in the case where a triangular face shares the boundary edge with the first hole in the first model, the array of holes is updated based on the triangular face sharing the boundary edge with the first hole in the first model. In the case where the updated array of holes includes at least two holes, the first tunnel is determined based on the first target hole. The first target hole is the largest hole in the updated array of holes. The first tunnel is obtained based on two holes that are connected to each other via two triangular faces. The first target hole in the updated array of holes is used as a new first hole, and the above steps are repeated until all holes in the array of holes have no untraversed common triangular face. The tunnel identification result of the first model is determined based on all the first tunnels. By traversing all triangular faces that share the boundary edge with the first hole on the first model and traversing each triangular face only once, it is possible to ensure that all the first tunnels on the first model are identified, thereby improving the accuracy and efficiency of tunnel identification.

Optionally, a specific implementation of the above step 202 includes:
(1) Determining the number of holes based on the triangular face sharing the boundary edge with the first hole in the first model.

Specifically, the triangular faces that share the boundary edge with the first hole in the first model are traversed. When traversing to the triangular face sharing the boundary edge with the first hole in the first model, the triangular face sharing the boundary edge with the first hole and the triangular faces that have been traversed may cause the number of holes to change or remain unchanged, thereby determining the number of holes.

That is, the currently traversed triangular face is added to the triangular faces that already have been traversed, and these triangular faces are connected according to the relative positional relationship in the first model. Because of the addition of new triangular faces, the number of holes may change.

(2) Updating the array of holes based on the number of holes.

Specifically, the array of holes may be updated according to the number of holes.

Optionally, the step of updating the array of holes based on the number of holes includes:
(a) In the case where the number of holes increases, determining at least two second holes; and updating the array of holes based on the at least two second holes.

Specifically, in the case where the number of holes increases, that is, a certain hole is split into two holes, at least two second holes are obtained. The split hole is deleted from the array of holes, and the hole information of the at least two second holes obtained by splitting is added to the array of holes, and different numbers are assigned to the at least two second holes, so as to update the array of holes.

It can be understood that the first model is traversed by taking the first hole as reference; and when traversing to the triangular face sharing the boundary edge with the first hole, the first hole may be split into two second holes due to the addition of the triangular face. Thus, the first hole may be deleted from the array of holes, and the hole information of the two second holes obtained by splitting is added to the array of holes.

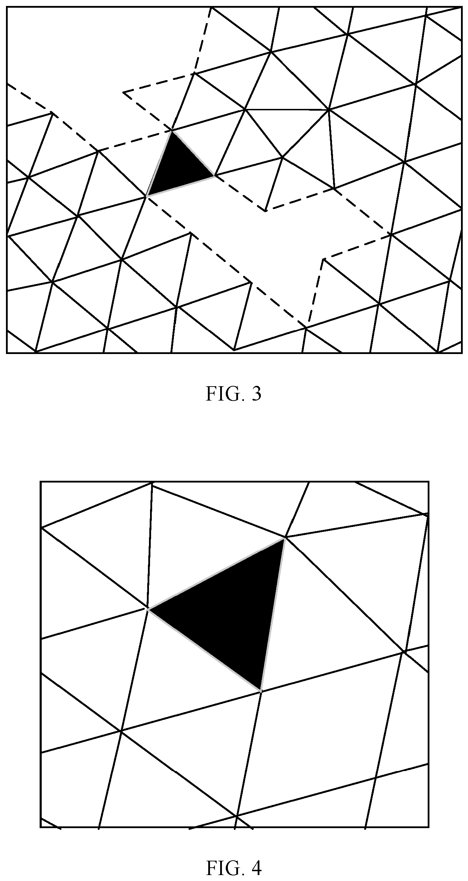

FIG. 3 is a schematic diagram of increasing the number of holes according to an embodiment of the present disclosure. As shown in FIG. 3, triangular faces are added by traversing the triangular faces that share boundary edges on the boundary of the three-dimensional model (as shown in FIG. 3, the triangular face with pure black background is a newly-added traversed triangular face). As can be seen from FIG. 3, one original hole is split into two holes, namely two holes shown by the dotted boxes in FIG. 3, due to the newly-added triangular face.

It should be noted that two triangular faces are not considered to be connected in the case where there is only one point connecting the two triangular faces, but two triangular faces are considered to be connected in the case where the two triangular faces have one common edge.

(b) In the case where the number of holes decreases, determining closed holes; and updating the array of holes based on the closed holes.

Specifically, in the case where the number of holes decreases, that is, a certain hole is closed, the closed hole is determined and deleted from the array of holes, thereby updating the array of holes.

That is, in the case where the triangular faces in the first model are traversed based on the first hole, the addition of the newly traversed triangular face makes the first hole closed. Therefore, the first hole needs to be deleted from the array of holes to complete the update of the array of holes.

FIG. 4 is a schematic diagram of decreasing the number of holes according to an embodiment of the present disclosure. As shown in FIG. 4, after a triangular face (i.e., a triangular face with black background) is added to the boundary of the three-dimensional model, one original hole (i.e., the first hole) is closed, thereby reducing one hole.

(c) In the case where the number of holes remains unchanged, determining an updated first hole; and updating the array of holes based on the updated first hole.

Specifically, in the case where the number of holes remains unchanged, that is, the first hole is enlarged, the updated first hole is determined, that is, the edge identifier of the boundary edge and the hole identifier of the enlarged first hole are added to the array of holes, thereby updating the array of holes.

It can also be understood that, in the case where the triangular faces that share the boundary edge with the first hole in the first model are traversed based on the first hole, the addition of the newly traversed triangular face does not change the number of holes, but the boundary edge of the first hole changes, so the hole information of the first hole in the array of holes needs to be updated.

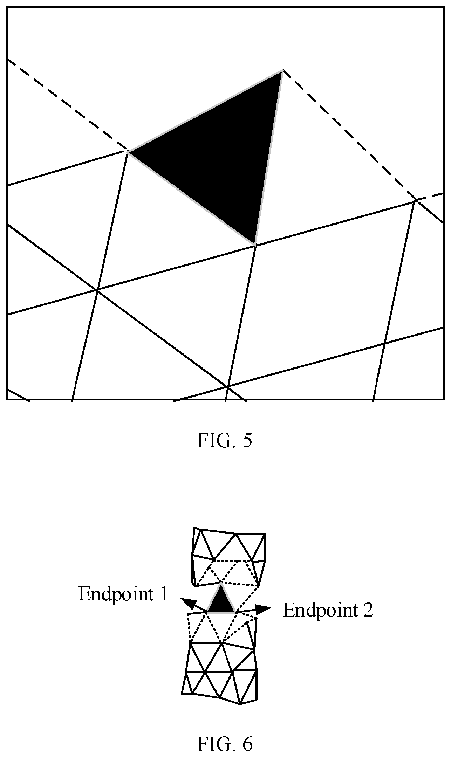

FIG. 5 is a schematic diagram of not changing the number of holes according to an embodiment of the present disclosure. As shown in FIG. 5, the addition of a triangular face (i.e., a triangular face with black background) to the boundary of the three-dimensional model does not change the number of holes, but the boundaries of the holes are changed.

In the present disclosure, in the case where the number of holes increases, at least two second holes are determined. In the case where the number of holes decreases, the closed hole is determined. In the case where the number of holes remains unchanged, the updated first hole is determined. In this way, the update of the array of holes is implemented, and then the identification of all first tunnels on the first model is implemented according to the largest hole in the updated array of holes, thereby improving the accuracy and efficiency of tunnel identification.

Optionally, In the case where there is no triangular face that shares the boundary edge with the first hole in the first model, the first hole is deleted from the array of holes and the array of holes is updated. Afterwards, the largest hole is reselected from the array of holes as a new first hole, and the process returns to steps 202 to 204.

Specifically, in the case where there is no triangular face that shares the boundary edge with the first hole in the first model, that is, the first hole currently being operated cannot find any adjacent triangular face sharing the boundary edge with the first hole on the first model, it means that the first hole has reached the boundary of the first model. In the case where there are a plurality of sub-models, it means that the first hole has reached the boundary of the sub-model where the first hole is located. Therefore, the first hole is deleted from the array of holes, thereby updating the array of holes.

Optionally, a specific implementation of the above step 203 includes:
determining a second target hole that shares a same boundary edge with the first target hole; and determining the first tunnel based on the first target hole and the second target hole.

Specifically, after the first target hole is obtained, the second target hole that shares the same boundary edge with the first target hole is determined, that is, the first target hole and the second target hole are connected, and then the first tunnel can be determined based on the first target hole and the second target hole.

It can be understood that there are differences in the naming of holes at different operations in the embodiments of the present disclosure. For example, in the case where the array of holes is updated based on the first hole, the first hole may be split into two holes due to the newly traversed triangular face, and the two holes obtained by splitting are called second holes. As the traversal proceeds, the number of second holes may gradually increase to more than two.

In some embodiments, after the first hole is split into two second holes, the first target hole may be one of the two second holes, the first target hole is the largest one of the two second holes, and the second target hole is the hole connected to the first target hole.

In an embodiment of the present disclosure, the second target hole that shares the same boundary edge with the first target hole is determined after the first target hole is updated based on the newly traversed triangular face.

The so-called second target hole that shares the same boundary edge with the first target hole after updating the first target hole based on the newly traversed triangular face can be understood as: an exemplary case is that the largest one among a plurality of second holes split from the first hole is always found as the new first hole (also called the first target hole), and the first target hole is continuously traversed and updated until a second target hole sharing a boundary edge with the first target hole is found. That is to say, the two holes are independent before updating based on the newly traversed triangular face, but after the first target hole in the array of holes is updated based on the newly traversed triangular face, the updated first target hole and the non-updated second target hole are connected based on the edge of the newly traversed triangular face. That is, the updated first target hole and the second target hole have the same boundary edge based on the newly traversed triangular face.

Exemplarily, there are many methods for updating the array of holes, which may, for example, include the following steps: 1. traversing a triangular face sharing a boundary edge with the first target hole as a newly added triangular face; 2. updating the boundary edge of the first target hole based on the newly added triangular face; 3. checking whether the updated boundary edge is a boundary edge shared by the second target hole; if not, completing the update of the array of holes and continuing to traverse the next triangular face; if so, deleting the boundary edge; 4. after deleting the boundary edge, connecting the remaining boundary edges of the first target hole with the remaining boundary edges of the second target hole in sequence to determine a merged hole, that is, a new first target hole; 5. deleting the second target hole. In layman's terms, after traversing a triangular face sharing a boundary edge with a boundary edge of the first target hole, it is found that the new boundary edge is the boundary edge of the second target hole, meaning that the first target hole and the second target hole are now a tunnel. That is to say, the size of the first target hole is dynamic. Before the above step 2 starts, the first target hole and the second target hole are connected by one triangular face. In the case where the above step 2 ends, the first target hole and the second target hole have a common boundary edge, that is, are connected by two triangular faces.

Since the first target hole is the largest hole in the updated array of holes, steps 202 to 204 are performed all the time for the largest hole, that is, the continuously updated first hole. Thus, the boundary edges of the second target hole are all at the first tunnel, the first tunnel has been identified, and the first target hole and the second target hole are merged into one hole after the update of the array of holes is completed, so the second target hole can be deleted from the updated array of holes, and the first target hole is continued to be traversed to search for the next tunnel.

FIG. 6 is a schematic diagram of the first tunnel according to an embodiment of the present disclosure. As shown in FIG. 6, after a triangular face (i.e., a triangular face with black background in FIG. 6) is added to the boundary of the three-dimensional model, the first target hole and the second target hole are connected together, and one tunnel is generated at this time. Before the triangular face with black background is added, two holes above and below the tunnel are independent. Because of the addition of the new triangular face, the two holes are connected together, that is, the first target hole and the second target hole have the same boundary edge, and the tunnel between the two holes is identified at this time.

In the present disclosure, after the array of holes is updated, that is, each time a hole is split, holes are merged or the hole information is updated, the largest hole in the updated array of holes is used as the first target hole. That is, the largest hole is selected to continue traversing, so as to determine the second target hole connected to the first target hole. The first tunnel is determined based on the first target hole and the second target hole, that is, the tunnel position is located until the first target hole merges with another small hole, so that the positioning point is located inside the tunnel. Also, the method of the present disclosure can cover all tunnels on the first model without missing any tunnel, thereby improving the comprehensiveness and accuracy of tunnel identification.

Optionally, for each of the first tunnels, a tunnel closed curve of the first tunnel is determined, where the tunnel closed curve is a closed curve corresponding to the shortest path encircling the first tunnel; the length of the tunnel closed curve is determined; and in the case where the length of the tunnel closure curve is less than a preset threshold, the first tunnel is repaired.

Specifically, for each first tunnel (the first tunnel is obtained based on two holes that are connected to each other via two triangular faces) on the first model, the tunnel closed curve of the first tunnel may be determined, where the tunnel closed curve is the closed curve corresponding to the shortest path encircling the first tunnel; the length of the tunnel closed curve may be determined according to the tunnel closed curve of the first tunnel; and the length of the tunnel closed curve is compared with the preset threshold. In the case where the length of the tunnel closed curve is less than the preset threshold, it means that the first tunnel is relatively small and the first tunnel needs to be repaired.

In the present disclosure, for each first tunnel, the tunnel closed curve of the first tunnel is determined, and then the length of the tunnel closed curve is determined. In the case where the length of the tunnel closed curve is less than the preset threshold, the first tunnel is repaired. By judging the tunnel size by the length of the tunnel closed curve after finding the tunnel closed curve, instead of specifying the search radius when searching, narrow and long tunnels can also be found, improving the accuracy of tunnel identification; and the tunnel with the length of the tunnel closed curve less than the preset threshold can be repaired, improving the efficiency of tunnel repair. Thus, the present disclosure provides a clear criterion to identify which tunnels are noise and can be safely removed. Moreover, the tunnel closed curve determined based on the embodiment of the present disclosure is most likely located inside the tunnel, and the appearance of the model will not be damaged during stitching, improving the repair effect.

Optionally, for each of the first tunnels, determining a tunnel closed curve of the first tunnel, includes:
copying the first model to form a second model; and for each of the first tunnels, on the second model: removing all the triangular faces that are processed in the first model, retaining one or more triangular faces at an intersection of the first target hole and the second target hole, deleting two connected triangular faces on the first tunnel, and executing a shortest path algorithm to obtain the tunnel closed curve of the first tunnel.

Specifically, the first model is copied to form the second model; and for each first tunnel, all processed triangular faces, i.e., the triangular faces that have been traversed in the first model, are deleted on the second model. The unprocessed triangular face at the intersection of the first target hole and the second target hole is retained, and two triangular faces that have been traversed at the intersection for connecting the first target hole and the second target hole are deleted. Any edge of the two connected triangular faces may be selected as two endpoints to determine the tunnel closed curve.

For example, the shortest path algorithm is executed based on the common edge between the triangular face traversed last in the first model and the first target hole that existed before a boundary edge was updated (the endpoint 1 and endpoint 2 as shown in FIG. 6), to obtain the shortest tunnel closed curve encircling the first tunnel. For example, the two endpoints of the common edge are used as the starting and ending points of the tunnel closing curve, and the shortest path encircling the first channel is obtained as the tunnel closed curve of the first channel. In the embodiment of the present disclosure, the second model can ensure that when the shortest path algorithm to obtain the tunnel closed curve, previously traversed triangular faces are excluded. This avoids selecting those triangular faces closer to the last traversed triangular face, so that the channel closed line is located inside the first channel as possible, consequently ensure that the appearance of the model will be not damaged when the channel tunnel closed curve is deleted.

Optionally, the step of repairing the first tunnel includes:
deleting, based on the tunnel closed curve, triangular faces within a preset range corresponding to the tunnel closed curve, to obtain two disconnected third target holes; and using a hole filling algorithm to fill each of the third target holes.

Specifically, the triangular faces within the preset range corresponding to the tunnel closed curve are deleted according to the determined tunnel closed curve of the first tunnel, to obtain two disconnected third target holes. That is, triangular faces connected to the tunnel closed curve are found on the first model, and adjacent triangular faces in a certain number of layers are expanded outward at the corresponding position of the first model. These triangular faces are deleted to form two disconnected third target holes at the first tunnel. The hole filling algorithm is used to fill each third target hole respectively to repair the first tunnel.

In the present disclosure, when repairing the first tunnel, the tunnel closed curve is expanded outward to adjacent triangular faces in a specified number of layers. This separates two disconnected holes, preventing self-intersection of triangular faces during repair, thereby improving the efficiency of repair.

The tunnel identification apparatus for the three-dimensional model provided by the present disclosure will be described below. The tunnel identification apparatus for the three-dimensional model described below and the tunnel identification method for the three-dimensional model described above can be referred to each other.

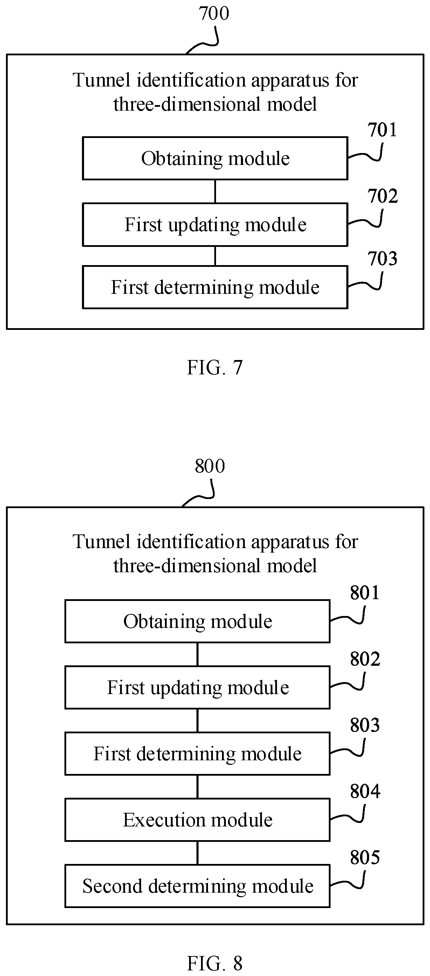

FIG. 7 is a schematic structural diagram of a tunnel identification apparatus for a three-dimensional model according to an embodiment of the present disclosure. As shown in FIG. 7, the tunnel identification apparatus 700 for the three-dimensional model includes: an obtaining module 701, a first updating module 702, and a first determining module 703:
the obtaining module 701 is configured to obtain and determine a first hole in a first model;
the first updating module 702 is configured to, in the case where a triangular face shares a boundary edge with the first hole in the first model, update an array of holes based on the triangular face sharing the boundary edge with the first hole and triangular faces that have been traversed in the first model; and
the first determining module 703 is configured to, in the case where an updated array of holes includes at least two holes, determine a first tunnel based on a first target hole; where the first target hole is a largest hole in the updated array of holes; and the first tunnel is obtained based on two holes that are connected to each other via two triangular faces.

Optionally, the obtaining module is specifically configured to:
in the case where the first hole for the first time is obtained, obtain an array of holes corresponding to a target triangular face in the first model; where the array of holes includes a first hole corresponding to the target triangular face; and a boundary edge of the first hole is an edge of the target triangular face.

Optionally, the obtaining module is specifically configured to:
after obtaining the first hole for the first time, select the largest hole from the updated array of holes as a new first hole.

Optionally, the first updating module is specifically configured to:
determine the number of holes based on the triangular face sharing the boundary edge with the first hole in the first model; and
update the array of holes based on the number of holes.

Optionally, the first updating module is specifically configured to:
in the case where the number of holes increases, determine at least two second holes; and update the array of holes based on the at least two second holes;
in the case where the number of holes decreases, determine closed holes; and update the array of holes based on the closed holes; and
in the case where the number of holes remains unchanged, determine an updated first hole; and update the array of holes based on the updated first hole.

Optionally, the first determining module is specifically configured to:
determine a second target hole that shares a same boundary edge with the first target hole after updating the first target hole based on a newly traversed triangular face; and
determine the first tunnel based on the first target hole and the second target hole.

Optionally, the apparatus further includes:
a third determining module configured to determine a tunnel closed curve of the first tunnel; where the tunnel closed curve is a closed curve corresponding to a shortest path encircling the first tunnel;
a fourth determining module configured to determine a length of the tunnel closed curve; and
a repairing module configured to, in the case where the length of the tunnel closed curve is less than a preset threshold, repair the first tunnel.

Optionally, the third determining module is specifically configured to:
copy the first model to form a second model; and
on the second model: delete all processed triangular faces in the first model, retain one or more triangular faces at an intersection of the first target hole and the second target hole, delete two connected triangular faces on the first tunnel, and execute a shortest path algorithm to obtain the tunnel closed curve of the first tunnel.

Optionally, the repairing module is specifically configured to:
delete, based on the tunnel closed curve, triangular faces within a preset range corresponding to the tunnel closed curve, to obtain two disconnected third target holes; and
use a hole filling algorithm to fill each of the third target holes.

Optionally, the third determining module is specifically configured to:
execute the shortest path algorithm based on a common edge between a triangular face traversed last in the first model and the first target hole that existed before a boundary edge was updated, to obtain a shortest tunnel closed curve encircling the first tunnel.

Optionally, the first updating module is specifically configured to traverse triangular faces adjacent to the first hole one by one in the first model to search for the triangular face sharing the boundary edge with the first hole.

Optionally, the first updating module is further configured to:
in the case where there is no untraversed triangular face that shares a boundary edge with the first hole in the first model, delete the first hole from the array of holes; and
reselect a largest hole from the array of holes as a new first hole, and return to execute: in the case where a triangular face shares the boundary edge with the first hole in the first model, updating the array of holes based on the triangular face sharing the boundary edge with the first hole in the first model, until there is no hole in the array of holes.

FIG. 8 is a schematic structural diagram of a tunnel identification apparatus for a three-dimensional model according to an embodiment of the present disclosure. As shown in FIG. 8, the tunnel identification apparatus 800 for the three-dimensional model includes: an obtaining module 801, a first updating module 802, a first determining module 803, an execution module 804, and a second determining module 805:
the obtaining module 801 is configured to obtain an array of holes corresponding to a target triangular face in a first model; where the array of holes includes a first hole corresponding to the target triangular face; and a boundary edge of the first hole is an edge of the target triangular face;
the first updating module 802 is configured to, in the case where a triangular face shares the boundary edge with the first hole in the first model, update the array of holes based on the triangular face sharing the boundary edge with the first hole and triangular faces that have been traversed in the first model;
the first determining module 803 is configured to, in the case where the updated array of holes includes at least two holes, determine a first tunnel based on a first target hole; where the first target hole is a largest hole in the updated array of holes; and the first tunnel is obtained based on two holes that are connected to each other via two triangular faces;
the execution module 804 is configured to take the first target hole in the updated array of holes as a new first hole, and repeat the above steps until there is no hole in a finally updated array of holes; and
the second determining module 805 is configured to determine a tunnel identification result of the first model based on all first tunnels.

In the tunnel identification apparatus for the three-dimensional model provided by the present disclosure, the array of holes corresponding to the target triangular face in the first model is obtained, where the array of holes includes the first hole corresponding to the target triangular face, and the boundary edge of the first hole is the edge of the target triangular face; in the case where a triangular face shares the boundary edge with the first hole in the first model, the array of holes is updated based on the triangular face sharing the boundary edge with the first hole in the first model; in the case where the updated array of holes includes at least two holes, the first tunnel is determined based on the first target hole, where the first target hole is the largest hole in the updated array of holes, and the first tunnel is obtained based on two holes that are connected to each other via two triangular faces; the first target hole in the updated array of holes is used as a new first hole, and the above steps are repeated until all holes in the array of holes have no common triangular face; and the tunnel identification result of the first model is determined based on all the first tunnels. By traversing all triangular faces that share the boundary edge with the first hole on the model and traversing each triangular face only once, the identification of all the first tunnels on the first model can be ensured, thereby improving the accuracy and efficiency of tunnel identification.

Optionally, the first updating module 802 is specifically configured to:
determine the number of holes based on the triangular face sharing the boundary edge with the first hole in the first model; and
update the array of holes based on the number of holes.

Optionally, the first updating module 802 is further configured to:
in the case where the number of holes increases, determine at least two second holes; and update the array of holes based on the at least two second holes;
in the case where the number of holes decreases, determine closed holes; and update the array of holes based on the closed holes; and
in the case where the number of holes remains unchanged, determine an updated first hole; and update the array of holes based on the updated first hole.

Optionally, the first determining module 803 is specifically configured to:
determine a second target hole that shares a same boundary edge with the first target hole after updating the first target hole based on a newly traversed triangular face; and
determine the first tunnel based on the first target hole and the second target hole.

Optionally, the tunnel identification device 800 for the three-dimensional model further includes:
a third determining module configured to, for each of the first tunnels, determine a tunnel closed curve of the first tunnel; where the tunnel closed curve is a closed curve corresponding to a shortest path encircling the first tunnel;
a fourth determining module configured to determine a length of the tunnel closed curve; and
a repairing module configured to, in the case where the length of the tunnel closed curve is less than a preset threshold, repair the first tunnel.

Optionally, the third determining module is specifically configured to:
copy the first model to form a second model; and
for each of the first tunnels, on the second model: delete all processed triangular faces in the first model, retain one or more triangular faces at an intersection of the first target hole and the second target hole, delete two connected triangular faces on the first tunnel, and execute a shortest path algorithm to obtain the tunnel closed curve of the first tunnel.

Optionally, the repairing module is specifically configured to:
delete, based on the tunnel closed curve, triangular faces within a preset range corresponding to the tunnel closed curve, to obtain two disconnected third target holes; and
use a hole filling algorithm to fill each of the third target holes.

Optionally, the third determining module is specifically configured to:
execute the shortest path algorithm based on a common edge between a triangular face traversed last in the first model and the first target hole that existed before a boundary edge was updated, to obtain a shortest tunnel closed curve encircling the first tunnel.

Optionally, the first updating module is specifically configured to traverse triangular faces adjacent to the first hole one by one in the first model to search for the triangular face sharing the boundary edge with the first hole.

Optionally, the first updating module is further configured to:
in the case where there is no untraversed triangular face that shares a boundary edge with the first hole in the first model, delete the first hole from the array of holes; and
reselect a largest hole from the array of holes as a new first hole, and return to execute steps B to D.

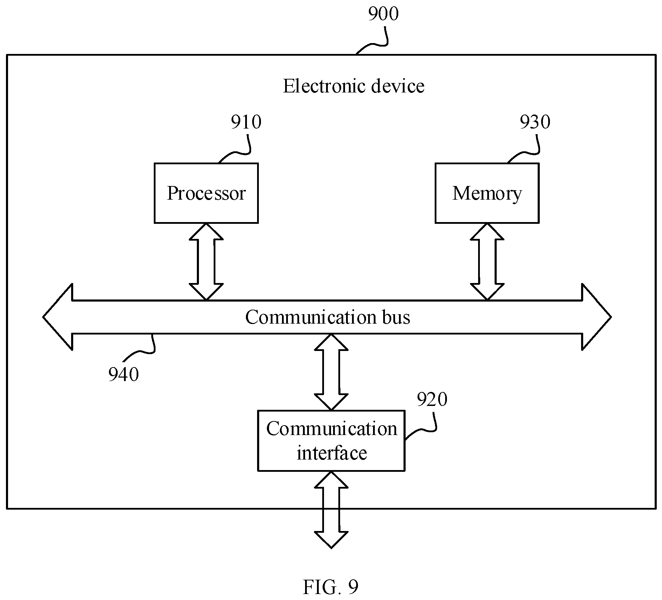

FIG. 9 is a schematic diagram of a physical structure of an electronic device according to an embodiment of the present disclosure. As shown in FIG. 9, the electronic device may include: a processor 910, a communication interface 720, a memory 730 and a communication bus 940, where the processor 910, the communication interface 920 and the memory 930 communicate with each other through the communication bus 940. The processor 910 may call logic instructions in the memory 930 to execute a tunnel identification method for a three-dimensional model, the method including:
101: determining a first hole in a first model;
102: in the case where a triangular face shares a boundary edge with the first hole in the first model, updating an array of holes based on the triangular face sharing the boundary edge with the first hole in the first model; and
103: in the case where the updated array of holes includes at least two holes, determining a first tunnel based on a first target hole; where the first target hole is a largest hole in the updated array of holes; and the first tunnel is obtained based on two holes that are connected to each other via two triangular faces.

Alternatively, the method includes:
step A: obtaining an array of holes corresponding to a target triangular face in a first model; where the array of holes includes a first hole corresponding to the target triangular face; and a boundary edge of the first hole is an edge of the target triangular face;
step B: in the case where a triangular face shares the boundary edge with the first hole in the first model, updating the array of holes based on the triangular face sharing the boundary edge with the first hole in the first model;
step C: in the case where the updated array of holes includes at least two holes, determining a first tunnel based on a first target hole; where the first target hole is a largest hole in the updated array of holes; and the first tunnel is obtained based on two holes that are connected to each other via two triangular faces;
step D: taking the first target hole in the updated array of holes as a new first hole, and repeating steps B to D until there is no hole in a finally updated array of holes; and
step E: determining a tunnel identification result of the first model based on all first tunnels.

In addition, the logic instructions in the memory 930 described above may be implemented in the form of software functional unit and, when sold or used as an independent product, may be stored in a computer-readable storage medium. Based on such understanding, the technical solution of the present disclosure essentially or a part that contributes to the prior art or a part of the technical solution may be embodied in the form of software product. The computer software product is stored in a storage medium, and includes several instructions used to enable a computer device (which may be a personal computer, server, or network device, etc.) to perform all or some of the steps of the methods described in various embodiments of the present disclosure. The above-mentioned storage medium includes: USB flash drive, mobile hard disk, Read-Only Memory (ROM), Random Access Memory (RAM), magnetic disk or compact disc or various media that can store the program codes.

In another aspect, the present disclosure further provides a computer program product including a computer program, which can be stored on a non-transitory computer-readable storage medium. When the computer program is executed by a processor, the computer can execute the tunnel identification method for the three-dimensional model provided above, the method including:
101: determining a first hole in a first model;
102: in the case where a triangular face shares a boundary edge with the first hole in the first model, updating an array of holes based on the triangular face sharing the boundary edge with the first hole and triangular faces that have been traversed in the first model; and
103: in the case where the updated array of holes includes at least two holes, determining a first tunnel based on a first target hole; where the first target hole is a largest hole in the updated array of holes; and the first tunnel is obtained based on two holes that are connected to each other via two triangular faces.

Alternatively, the method includes:
step A: obtaining an array of holes corresponding to a target triangular face in a first model; where the array of holes includes a first hole corresponding to the target triangular face; and a boundary edge of the first hole is an edge of the target triangular face;
step B: in the case where a triangular face shares the boundary edge with the first hole in the first model, updating the array of holes based on the triangular face sharing the boundary edge with the first hole and triangular faces that have been traversed in the first model;
step C: in the case where the updated array of holes includes at least two holes, determining a first tunnel based on a first target hole; where the first target hole is a largest hole in the updated array of holes; and the first tunnel is obtained based on two holes that are connected to each other via two triangular faces;
step D: taking the first target hole in the updated array of holes as a new first hole, and repeating steps B to D until there is no hole in a finally updated array of holes; and
step E: determining a tunnel identification result of the first model based on all first tunnels.

In yet another aspect, the present disclosure further provides a non-transitory computer-readable storage medium storing a computer program thereon. The computer program, when executed by a processor, implements the tunnel identification method for the three-dimensional model provided above, the method including:
101: determining a first hole in a first model;
102: in the case where a triangular face shares a boundary edge with the first hole in the first model, updating an array of holes based on the triangular face sharing the boundary edge with the first hole and triangular faces that have been traversed in the first model; and
103: in the case where the updated array of holes includes at least two holes, determining a first tunnel based on a first target hole; where the first target hole is a largest hole in the updated array of holes; and the first tunnel is obtained based on two holes that are connected to each other via two triangular faces.

Alternatively, the method includes:
step A: obtaining an array of holes corresponding to a target triangular face in a first model; where the array of holes includes a first hole corresponding to the target triangular face; and a boundary edge of the first hole is an edge of the target triangular face;
step B: in the case where a triangular face shares the boundary edge with the first hole in the first model, updating the array of holes based on the triangular face sharing the boundary edge with the first hole and triangular faces that have been traversed in the first model;
step C: in the case where the updated array of holes includes at least two holes, determining a first tunnel based on a first target hole; where the first target hole is a largest hole in the updated array of holes; and the first tunnel is obtained based on two holes that are connected to each other via two triangular faces;
step D: taking the first target hole in the updated array of holes as a new first hole, and repeating steps B to D until there is no hole in a finally updated array of holes; and
step E: determining a tunnel identification result of the first model based on all first tunnels.

The device embodiments described above are merely illustrative, where the units described as separate components may or may not be physically separated, and the components displayed as units may or may not be physical units, that is, may be located in one place or may be distributed over multiple network units. Some or all of the modules may be selected according to the actual needs to achieve the objects of the solutions of the embodiments. Those ordinary skill in the art can understand and implement without creative labor.

Through the above description of the embodiments, it is clear for those skilled in the art that the embodiments may be implemented by means of software plus the required generalpurpose hardware platform, or of course, may be implemented by means of hardware. Based on such understanding, the above technical solution in itself or the part which contributes to the prior art can be embodied in the form of software product. The computer software product can be stored in the computer readable storage medium such as ROM/RAM, disk, compact disc or the like, and include a number of instructions used to enable a computer equipment (which can be personal computer, server, network equipment or the like) to perform the methods described in various embodiments or some parts of the embodiments.

Finally it should be noted that the above embodiments are only used to illustrate but not limit the technical solutions of the present disclosure; although the disclusure has been illustrated in details by reference to the above embodiments, it should be understood by those ordinary skilled in the art that they can still modify the technical solutions recorded in all the above embodiments or equivalently replace some technical features therein; and these modifications and replacements do not make the essence of the corresponding technical solutions depart from the spirit and scope of the technical solutions of all the embodiments of the present disclosure.

## Claims

1. A tunnel identification method for a three-dimensional model, comprising:
determining a first hole in a first model;
in a case where a triangular face shares a boundary edge with the first hole in the first model, updating an array of holes based on the triangular face sharing the boundary edge with the first hole and triangular faces that have been traversed in the first model; and
in a case where the updated array of holes comprises at least two holes, determining a first tunnel based on a first target hole; wherein the first target hole is a largest hole in the updated array of holes; and the first tunnel is obtained based on two holes that are connected to each other via two triangular faces.

2. The method of claim 1, wherein, in a case where the first hole for first time is obtained, determining the first hole in the first model comprises:
obtaining an array of holes corresponding to a target triangular face in the first model; wherein the array of holes comprises a first hole corresponding to the target triangular face; and a boundary edge of the first hole is an edge of the target triangular face.

3. The method of claim 1, wherein, after obtaining the first hole for first time, determining the first hole in the first model comprises:
selecting the largest hole from the updated array of holes as a new first hole.

4. A tunnel identification method for a three-dimensional model, comprising:
step A: obtaining an array of holes corresponding to a target triangular face in a first model; wherein the array of holes comprises a first hole corresponding to the target triangular face; and a boundary edge of the first hole is an edge of the target triangular face;
step B: in a case where a triangular face shares the boundary edge with the first hole in the first model, updating the array of holes based on the triangular face sharing the boundary edge with the first hole and triangular faces that have been traversed in the first model;
step C: in a case where the updated array of holes comprises at least two holes, determining a first tunnel based on a first target hole; wherein the first target hole is a largest hole in the updated array of holes; and the first tunnel is obtained based on two holes that are connected to each other via two triangular faces;
step D: taking the first target hole in the updated array of holes as a new first hole, and repeating steps B to D until there is no hole in a finally updated array of holes; and
step E: determining a tunnel identification result of the first model based on all first tunnels.

5. The method of claim 4, wherein updating the array of holes based on the triangular face sharing the boundary edge with the first hole in the first model, comprises:
determining the number of holes based on the triangular face sharing the boundary edge with the first hole in the first model; and
updating the array of holes based on the number of holes.

6. The method of claim 5, wherein updating the array of holes based on the number of holes, comprises:
in a case where the number of holes increases, determining at least two second holes; and updating the array of holes based on the at least two second holes;
in a case where the number of holes decreases, determining closed holes; and updating the array of holes based on the closed holes; and
in a case where the number of holes remains unchanged, determining an updated first hole; and updating the array of holes based on the updated first hole.

7. The method of claim 4, wherein determining the first tunnel based on the first target hole, comprises:
determining a second target hole that shares a same boundary edge with the first target hole after updating the first target hole based on a newly traversed triangular face; and
determining the first tunnel based on the first target hole and the second target hole.

8. The method of any one of claims 4 to 7, further comprising:
for each of the first tunnels, determining a tunnel closed curve of the first tunnel; wherein the tunnel closed curve is a closed curve corresponding to a shortest path encircling the first tunnel;
determining a length of the tunnel closed curve; and
in a case where the length of the tunnel closed curve is less than a preset threshold, repairing the first tunnel.

9. The method of claim 8, wherein for each of the first tunnels, determining the tunnel closed curve of the first tunnel, comprises:
copying the first model to form a second model; and
for each of the first tunnels, on the second model: deleting all processed triangular faces in the first model, retaining one or more triangular faces at an intersection of the first target hole and the second target hole, deleting two connected triangular faces on the first tunnel, and executing a shortest path algorithm to obtain the tunnel closed curve of the first tunnel.

10. The method of claim 8, wherein repairing the first tunnel, comprises:
deleting, based on the tunnel closed curve, triangular faces within a preset range corresponding to the tunnel closed curve, to obtain two disconnected third target holes; and
using a hole filling algorithm to fill each of the third target holes.

11. The method of claim 9, wherein executing the shortest path algorithm to obtain the tunnel closed curve of the first tunnel, comprises:
executing the shortest path algorithm based on a common edge between a triangular face traversed last in the first model and the first target hole that existed before a boundary edge was updated, to obtain a shortest tunnel closed curve encircling the first tunnel.

12. The method of claim 4, wherein triangular faces adjacent to the first hole are traversed one by one in the first model to search for the triangular face sharing the boundary edge with the first hole.

13. The method of claim 4, further comprising:
in a case where there is no untraversed triangular face that shares a boundary edge with the first hole in the first model, deleting the first hole from the array of holes; and
reselecting the largest hole from the array of holes as a new first hole, and returning to execute steps B to D.

14. A tunnel identification apparatus for a three-dimensional model, comprising:
an obtaining module configured to obtain and determine a first hole in a first model;
a first updating module configured to, in a case where a triangular face shares a boundary edge with the first hole in the first model, update an array of holes based on the triangular face sharing the boundary edge with the first hole and triangular faces that have been traversed in the first model; and
a first determining module configured to, in a case where the updated array of holes comprises at least two holes, determine a first tunnel based on a first target hole; wherein the first target hole is a largest hole in the updated array of holes; and the first tunnel is obtained based on two holes that are connected to each other via two triangular faces.

15. A tunnel identification apparatus for a three-dimensional model, comprising:
an obtaining module configured to obtain an array of holes corresponding to a target triangular face in a first model; wherein the array of holes comprises a first hole corresponding to the target triangular face; and a boundary edge of the first hole is an edge of the target triangular face;
a first updating module configured to, in a case where a triangular face shares the boundary edge with the first hole in the first model, update the array of holes based on the triangular face sharing the boundary edge with the first hole and triangular faces that have been traversed in the first model;
a first determining module configured to, in a case where the updated array of holes comprises at least two holes, determine a first tunnel based on a first target hole; wherein the first target hole is a largest hole in the updated array of holes; and the first tunnel is obtained based on two holes that are connected to each other via two triangular faces;
an execution module configured to take the first target hole in the updated array of holes as a new first hole, and repeat the above steps until there is no hole in a finally updated array of holes; and
a second determining module configured to determine a tunnel identification result of the first model based on all first tunnels.

16. An electronic device comprising a memory, a processor, and a computer program stored in the memory and executable on the processor, wherein the processor implements the tunnel identification method for the three-dimensional model of any one of claims 1 to 13 when executing the program.

17. A non-transitory computer-readable storage medium storing a computer program thereon, wherein the computer program, when executed by a processor, implements the tunnel identification method for the three-dimensional model of any one of claims 1 to 13.
